**Europäisches Patentamt**

(19) **European Patent Office**

**Office européen des brevets**

(11) Veröffentlichungsnummer: **0 085 140**
**B1**

(12) **EUROPÄISCHE PATENTSCHRIFT**

(45) Veröffentlichungstag der Patentschrift:
04.09.85

(21) Anmeldenummer: **82109489.3**

(22) Anmeldetag: **14.10.82**

(51) Int. Cl.⁴: **H 01 F 1/00,** H 01 F 10/16,
G 11 C 11/04, H 01 F 41/14,
H 01 F 3/06, H 01 F 41/04

(54) **Magnetischer Draht.**

(30) Priorität: **30.01.82 DE 3203133**

(43) Veröffentlichungstag der Anmeldung:
**10.08.83 Patentblatt 83/32**

(45) Bekanntmachung des Hinweises auf die Patenterteilung:
**04.09.85 Patentblatt 85/36**

(84) Benannte Vertragsstaaten:
**FR GB IT**

(56) Entgegenhaltungen:
**DE - A - 1 804 793**
**DE - A - 2 933 337**
**DE - B - 1 949 147**
**GB - A - 1 604 204**
**GB - A - 1 604 205**
**US - A - 3 818 465**
**US - A - 3 820 090**
**US - A - 3 892 118**
**US - A - 4 065 757**

(73) Patentinhaber: **Licentia Patent-Verwaltungs-GmbH,
Theodor-Stern-Kai 1, D-6000 Frankfurt/Main 70 (DE)**

(72) Erfinder: **Kanbach, Helmut, Dr. rer.nat., Bachstrasse 11,
D-6054 Rodgau 2 (DE)**

(74) Vertreter: **Lertes, Kurt, Dr. et al, Licentia
Patent-Verwaltungs-GmbH Theodor-Stern-Kai 1,
D-6000 Frankfurt/M 70 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung betrifft einen magnetischen Draht zur Verwendung als bistabiles Schaltelement in Verbindung mit einer Induktionsspule, bestehend aus einem Kern und einer auf diesem aufgebrachten, magnetisierbaren, magnetostriktiven Schicht, wobei der Kern und die Schicht in Längsachse gegeneinander tordiert sind.

Aus den US-PS Nrn. 3818465 und 3820090 ist ein magnetisch bistabiles Schaltelement bekannt mit einem magnetischen Draht, der aus einem Kern und einer diesen umgebenden Schicht besteht. Dieser Draht wird mittels einer Kalttorsionswechselverfestigungs- und Dehnungsbehandlung erzeugt, wobei ein magnetisch weicher Kern und eine magnetisch harte Hülle erzeugt werden. Damit ergibt sich in der Schicht des Drahtes eine höhere Koerzitivfeldstärke als im Kern. Der bekannte magnetische Draht weist jedoch mehrere Nachteile auf. Um eine den technischen Anforderungen genügende Ummagnetisierungsgeschwindigkeit zu erreichen, sind sehr kleine Korngrössen erforderlich, wie sie bei erschmolzenen Legierungen nur schwer erreichbar sind. Ferner lässt sich das Herstellungsverfahren nur an relativ kurzen Drahtstücken von etwa 30 cm Länge durchführen, da die Kalttorsionswechselverfestigung nicht gleichmässig über der Länge realisierbar ist. Das führt unter anderem auch dazu, dass je nach Länge des Drahtes unterschiedliche elektrische Spannungsimpulse in der Induktionsspule erhalten werden.

Aus der US-PS Nr. 4236230 ist ein Verfahren zur Herstellung eines bistabilen magnetischen Speicherelements bekannt, das darin besteht, den Draht zunächst zu tordieren, anschliessend die Schicht auf den Draht aufzubringen und schliesslich die Torsion vom Kerndraht wegzunehmen, so dass die Schicht selbst tordiert wird, wobei der Draht unter einer Resttorsion verbleibt. Damit der bekannte magnetische Draht die Forderung nach einem Speicherelement erfüllt, besteht der Kern aus einem Material, das wesentlich weicher magnetisch als die auf dem Kern aufgebrachte Schicht ist.

Der Erfindung liegt die Aufgabe zugrunde, einen bistabilen magnetischen Draht verfügbar zu machen, der als Schaltelement mit guten Schalteigenschaften verwendbar ist.

Diese Aufgabe wird gemäss Erfindung dadurch gelöst, dass der Kern aus einem härter magnetischen Werkstoff und die Schicht aus einem weicher magnetischen Werkstoff bestehen.

Weiterbildungen der Erfindung sind den Unteransprüchen zu entnehmen.

Der magnetische Draht gemäss der Erfindung weist eine hohe Ummagnetisierungsgeschwindigkeit und damit sehr gute Schalteigenschaften auf. Es lassen sich auch Drähte grösserer Länge mit homogenen Eigenschaften herstellen. Zur Herstellung der Drahtes eignet sich insbesondere die galvanische Abscheidung der Schicht auf dem Kern.

## Vorteile

Ein Vorteil besteht darin, dass der magnetische Draht aus verschiedenen Stoffen aufgebaut ist. Die magnetischen Eigenschaften können dementsprechend durch freie Stoffwahl und Dimensionierung günstig eingestellt werden. Je nach Stoffwahl und Anzahl der Schichten können magnetisch mono-, bi- oder mehrfachstabile Drähte erzeugt werden. Da mit dem angewandten galvanischen Verfahren magnetisch aktive Schichten mit äusserst kleinen Korngrössen von beispielsweise 100 000 Körnern/mm² abgeschieden werden können, ergibt sich daraus ein günstiges magnetisches Schaltverhalten.

## Darstellung der Erfindung

Die Erfindung wird nachstehend anhand eines in der Zeichnung schematisch dargestellten Ausführungsbeispieles näher erläutert. Es zeigen:

Fig. 1 eine Längsansicht eines magnetischen Drahtsegmentes mit aufgebrachter Induktionsspule,

Fig. 2 eine Schnittansicht des magnetischen Drahtsegmentes mit zwei Schichten unterschiedlicher magnetischer Härte,

Fig. 3 eine Vorrichtung zur Aufbringung einer magnetostriktiven Schicht auf den Kern eines magnetischen Drahtes,

Fig. 4a, 4b die bei einer Ummagnetisierung eines magnetisch bistabilen Drahtsegmentes möglichen Magnetisierungszustände.

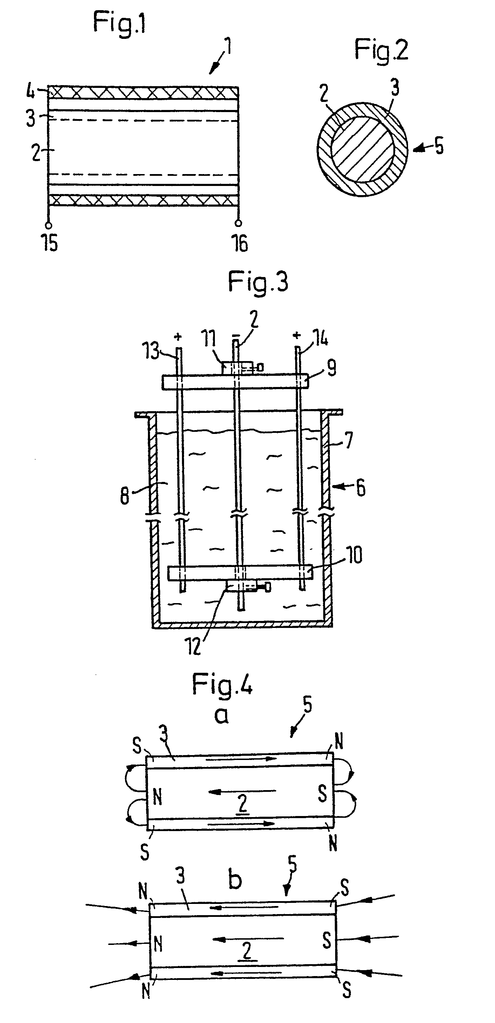

Aus den Fig. 1 und 2 ist ein magnetisches Bauelement 1 ersichtlich, welches aus einem Drahtsegment 5 mit einem Kern 2 und einer auf diesem aufgebrachten tordierten, magnetostriktiven Schicht 3 sowie aus einer Induktionsspule 4 besteht.

Besteht der Kern 2 aus einem ferromagnetischen Werkstoff, so handelt es sich um ein magnetisch bistabiles Bauelement, besteht der Kern 2 dagegen aus einem nicht magnetisierbaren Werkstoff, handelt es sich um ein magnetisch monostabiles Bauelement.

Bei einem magnetisch bistabilen Bauelement mit einem härtermagnetischen Kern 2 und einer weichermagnetischen Schicht 3 kann der hartmagnetische Kern 2 eine Legierung aus Co, Fe, V und Cr sein, wie eine solche unter der Bezeichnung „Koerflex 300" bekannt ist; das Drahtsegment 5 hat eine Länge von etwa 20 mm und einen Durchmesser von etwa 0,3 mm. Die Schicht 3 ist zweckmässig eine NiFe-Legierung mit einer Dicke von etwa 20 μm; zwecks Erzielung günstiger magnetostriktiver Eigenschaften der galvanisch aufgebrachten Schicht 3 ist eine Zusammensetzung von 50 bis 80 Gew.-% Ni und Rest Fe vorteilhaft. Damit ist auch eine gute Anpassung der Wärmeausdehnungskoeffizienten von Kern 2 und Schicht 3 erreicht, so dass ein Einsatz des Drahtsegmentes 5 in einem relativ grossen Temperaturbereich möglich ist.

Vor Aufbringung der Schicht 3 auf den Kern 2, welcher aus der vorstehend genannten Legierung besteht, werden an diesem die erforderlichen härtermagnetischen Eigenschaften (Koerzitivfeldstärke, Remanenz) nach vorangehender Kaltverformung mittels einer Anlasstemperaturbehandlung bei Temperaturen von etwa 400 bis 500° C eingestellt.

Die NiFe-Schicht 3 wird zweckmässig galvanisch auf dem härtermagnetischen Kern 2 abgeschieden, wie in der Fig. 3 angedeutet ist.

Die Vorrichtung 6 nach der Fig. 3 umfasst einen Behälter 7, in welchem sich als galvanisches Legierungsbad beispielsweise ein mit Borsäure gepufferter Sulfat-Chlorid-Elektrolyt 8 mit weiteren organischen Zusätzen befindet, in welchem ein aus Isolierstücken 9, 10 mit Halterungen 11, 12 und Anoden 13, 14 bestehendes Gestell getaucht ist. Zwischen den Halterungen 11, 12 ist der härtermagnetische Kern 2 als Kathode unter geringer Zugspannung zwecks Begradigung eingespannt.

An die Anoden 13, 14 und den Kern 2 ist eine Gleichspannung gelegt, wie durch +/- angedeutet ist.

Vor Eintauchen des den Kern 2 tragenden Gestells in den Elektrolyten 8 ist dem Kern 2 durch Verdrehen der drehbaren Halterung 11 um seine Längsachse eine definierte Torsionsspannung erteilt, mit der dieser in den Elektrolyten 8 eingebracht wird. Hat sich eine NiFe-Schicht 3 in gewünschter Dicke auf dem Kern 2 gebildet, so wird das Gestell mit Kern 2 und aufgebrachter Schicht 3 aus dem Elektrolyten 8 entfernt und der so gebildete magnetische Draht aus den Halterungen 11, 12 genommen. Unter dem Einfluss des tordierten Kernes 2 dreht sich der aus Kern 2 und Schicht 3 bestehende magnetische Draht entsprechend der vorgegebenen Torsion des Kernes 2 sowie der Dicke und den Torsionseigenschaften der Schicht 3 um einen bestimmten Winkel pro Längeneinheit in Richtung der Ausgangslage des Kernes 2 zurück, wodurch der Schicht 3 eine Torsion in Längsachse erteilt wird und diese somit eine axiale magnetische Anisotropie erhält. Neben diesen Torsionsspannungen enthält die Schicht 3 noch Zugspannungen, bedingt durch die Art der Legierungsabscheidung. Die Zusammensetzung der Schicht 3 kann so gewählt werden, dass die erzeugten Zugspannungen sich bezüglich einer raschen Ummagnetisierung der Schicht 3 positiv auswirken. Der Kern 2 kann auch, wie nicht weiter dargestellt ist, kontinuierlich durch ein entsprechendes galvanisches Legierungsbad geführt werden.

Der magnetische Draht kann anschliessend noch einer Wärmebehandlung von etwa 1 h bei etwa 300 bis 400° C unterzogen werden, wodurch etwa aufgenommener Wasserstoff ausgetrieben wird, die Schicht 3 hinsichtlich der Spannungen homogenisiert wird, wobei die Spannungen jedoch nicht abgebaut werden, und die Schicht 3 hinsichtlich der magnetischen Eigenschaften künstlich gealtert wird; dadurch wird verhindert, dass bei einem Einsatz des magnetischen Drahtes bei hohen Temperaturen langfristig Änderungen seiner magnetischen Eigenschaften auftreten.

Nach dem vorstehend beschriebenen Verfahren kann auch ein magnetisch bistabiler Draht mit einem weichermagnetischen Kern 2 und einer härtermagnetischen Schicht 3 erzeugt werden; dazu eignet sich beispielsweise ein Kern 2 aus einer weichmagnetischen NiFe-Legierung und eine galvanische Schicht 3 aus einer Legierung mit den Elementen Nickel und/oder Kobalt und/oder Eisen.

Wird anstelle eines ferromagnetischen Kernes 2 ein Kern aus einem im wesentlichen nicht magnetisierbaren, beispielsweise aus einem para- oder diamagnetischen Material verwendet, das jedoch torsionsfähig, steif und elektrisch leitend sein muss, dann ergibt sich nach Aufbringung der Schicht 3 auf einen derartigen Kern ein magnetisch monostabiler Draht. Als Kernmaterialien können beispielsweise Titan- oder Kupferlegierungen od.dgl. verwendet werden. Der Kern 2 kann auch aus einem elektrisch nicht leitenden Material bestehen, wobei sich wieder ein magnetisch monostabiler Draht ergibt; besteht der Kern 2 aus einer harten Kunststoff- oder Glasfaser, so muss diese vor Aufbringung der Schicht 3 durch aufgedampftes oder chemisch abgeschiedenes Material oberflächlich elektrisch leitend gemacht werden.

Durch Aufbringung mehrerer magnetisierbarer, magnetostriktiver Schichten auf den unter äusserer Torsion stehenden Kern 2 werden magnetisch tri- und mehrfachstabile Drähte erzielt.

Der magnetisch mono- oder mehrfachstabile Draht wird nach der Beschichtung in Drahtsegmente 5 von etwa 10 bis 30 mm Länge zerschnitten und gemäss Fig. 1 mit einer Induktionsspule 4 bestimmter Windungszahl versehen.

Bei einer Ummagnetisierung der tordierten, magnetostriktiven Schicht 3 mittels eines äusseren Magnetfeldes tritt an den Anschlüssen 15, 16 der Spule 4 ein Spannungsimpuls auf. Das Spannungsintegral — charakterisiert durch den Maximalwert der Spannung und die Impulshalbwertsbreite — ist unabhängig von der Art der Magnetfeldanregung und konstant. Der Wert des Spannungsintegrals hängt vom Volumen der Schicht 3 und von deren magnetischen Eigenschaften (im wesentlichen der Sättigungsmagnetisierung) ab, die durch die chemische Zusammensetzung gegeben sind. Je nachdem, ob das Drahtsegment 5 magnetisch mono- oder mehrfachstabil ist, ergibt sich ein unterschiedliches Ummagnetisierungsverhalten der magnetostriktiven Schicht 3.

Bei der bistabilen Ausführungsform des Drahtsegmentes 5 ist zu unterscheiden zwischen symmetrischer und asymmetrischer Magnetfeldanregung; bei symmetrischer Magnetfeldanregung und bei Magnetfeldamplituden grösser als die Koerzitivfeldstärke des härtermagnetischen Kernes 2 hängt die der Schicht 3 zuzuordnende maximale Induktionsspannung im wesentlichen von der Geschwindigkeit der Magnetfeldstärkeänderung ab. Wird die Koerzitivfeldstärke des härtermagnetischen Kernes 2 nicht überschritten, dann kommt der Streufluss des härtermagnetischen Kernes 2 vermehrt zur Wirkung, so dass die Ummagnetisierung der Schicht 3 neben der äusseren Feldstärkeänderungsgeschwindigkeit auch noch von der Geschwindigkeit der Umverteilung des inneren Streuflusses abhängt.

Bei einer asymmetrischen Magnetfeldanregung wird der Streufluss des härtermagnetischen Kernes 2 ausgenutzt; wird das magnetische Drahtsegment 5 nach der einen Magnetfeldrichtung über die Koerzitivfeldstärke des härtermagnetischen Kernes 2 hinaus aufmagnetisiert und anschliessend in der anderen Richtung bis kurz vor die Koerzitivfeldstärke des härtermagnetischen Kernes 2 ummagnetisiert, so ergibt sich beim neuerlichen Ummagnetisieren der Schicht 3 in die Ausgangsrichtung ein hoher und schmaler Spannungsimpuls (Spitzenspannung etwa 4 V, Halbwertszeit etwa 15 µs); dieser Impuls hängt nur unwesentlich von der Geschwindigkeit der äusseren Feldstärkeänderung ab und tritt bei einer bestimmten magnetischen Schwellwertfeldstärke auf (etwa 10 A/cm).

Wie in der Fig. 4 angedeutet, sind beim magnetisch bistabilen Drahtsegment 5 zwei unterschiedliche Magnetisierungszustände möglich. Nach Fig. 4a kann sich der Streufluss des härtermagnetischen Kernes 2 in der weichermagnetischen Schicht 3 schliessen; nach Ummagnetisieren der Schicht 3 ergibt sich ein Magnetisierungszustand gemäss Fig. 4b. Beim Übergang vom geschlossenen Zustand (Fig. 4a) in den offenen Zustand (Fig. 4b) wirkt die schnelle Umverteilung des Streuflusses des härtermagnetischen Kernes 2 beschleunigend auf die Ummagnetisierung der weichermagnetischen, magnetostriktiven Schicht 3. Diese innere, gewissermassen im magnetischen Drahtsegment 5 eingebaute Magnetfeldänderung verläuft zeitlich wesentlich rascher als die äussere Magnetfeldstärkeänderung, die beispielsweise durch bewegte Permanentmagnete erzielt wird, und kann zur Erzeugung von Spannungsimpulsen mittels der zugeordneten Induktionsspule 4 (Fig. 1) verwendet werden.

Bei der monostabilen Ausführungsform ergibt sich aufgrund der Abhängigkeit der Ummagnetisierungsgeschwindigkeit von der zeitlichen Änderung der äusseren Magnetfeldstärke an der Induktionsspule ein Spannungsimpuls, der in seiner Höhe und Breite von dieser zeitlichen Änderung der äusseren Magnetfeldstärke abhängig ist.

## Patentansprüche

1. Magnetischer Draht (5) zur Verwendung als bistabiles Schaltelement (1) in Verbindung mit einer Induktionsspule (4), bestehend aus einem Kern (2) und einer auf diesem aufgebrachten, magnetisierbaren, magnetostriktiven Schicht (3), wobei der Kern (2) und die Schicht (3) in Längsachse gegeneinander tordiert sind, dadurch gekennzeichnet, dass der Kern (2) aus einem härtermagnetischen Werkstoff und die Schicht (3) aus einem weichermagnetischen Werkstoff bestehen.

2. Magnetischer Draht nach Anspruch 1, dadurch gekennzeichnet, dass die Schicht (3) eine magnetostriktive Legierung aus Nickel/Eisen, Eisen/Kobalt, Nickel/Kobalt oder Nickel/Eisen/Kobalt ist.

3. Magnetischer Draht nach Anspruch 2, dadurch gekennzeichnet, dass die Schicht (3) eine Legierung mit 50 bis 80% Nickel und Rest Eisen ist.

## Claims

1. Magnetic wire (5) for use as bistable switching element (1) in combination with an induction coil (4) consisting of a core (2) and a magnetisable magnetostrictive layer (3) applied thereon, wherein the core (2) and the layer (3) are twisted each relative to the other in the longitudinal axis, characterised thereby, that the core (2) consists of a harder magnetic material and the layer (3) consists of a softer magnetic material.

2. Magnetic wire according to Claim 1, characterised thereby, that the layer (3) is a magnetostrictive alloy of nickel/iron, iron/cobalt, nickel/cobalt or nickel/iron/cobalt.

3. Magnetic wire acording to Claim 1, characterised thereby, that the layer (3) is an alloy with 50 to 80% being nickel and the remainder being iron.

## Revendications

1. Fil magnétique (5) pour utilisation en tant qu'élément de commutation bistable (1) en combinaison avec une bobine d'induction (4), constitué d'une âme (2) et d'une couche magnétostrictive magnétisable (3) appliquée sur cette âme, l'âme (2) et la couche (3) étant tordues l'une par rapport à l'autre sur l'axe longitudinal, caractérisé en ce que l'âme (2) est en une matière magnétique plus dure et la couche (3) en une matière magnétique plus douce.

2. Fil magnétique selon la revendication 1, caractérisé en ce que la couche (3) est un alliage magnétostrictif en nickel/fer, fer/cobalt, nickel/cobalt ou nickel/fer/cobalt.

3. Fil magnétique selon la revendication 2, caractérisé en ce que la couche (3) est un alliage comportant de 50 à 80% de nickel, le reste étant le fer.

## Fig.1

## Fig.2

## Fig.3

## Fig.4

a

b